# EUROPEAN PATENT SPECIFICATION

(11) **EP 3 109 210 B1**
(45) Date of publication and mention of the grant of the patent: **11.09.2019**
(21) Application number: 15173661.8
(22) Date of filing: 24.06.2015
(51) Int. Cl.: C03C 17/00, B05B 16/00, B05B 16/60, C23C 16/455, C23C 16/54

(54) **COATING APPARATUS FOR CONTAINERS, PROCESS OF APPLYING A COATING AND USE OF THE COATING APPARATUS**
BESCHICHTUNGSVORRICHTUNG FÜR BEHÄLTER, VERFAHREN ZUR BESCHICHTUNG UND VERWENDUNG DER BESCHICHTUNGSVORRICHTUNG
APPAREIL DE REVETEMENT POUR RECIPIENTS, PROCEDE D'APPLICATION D'UN REVETEMENT ET UTILISATION DE L'APPAREIL DE REVETEMENT

(43) Date of publication of application: 28.12.2016
(73) Proprietor: ARKEMA BV, NL-3196 KE Vondelingenplaat-Rotterdam (NL)
(72) Inventor: Meurer, Oliver, ALLEMAGNE (DE); Wagemakers, Joannes Theodorus Maria, PAYS BAS (NL)
(74) Representative: Hérard, Elise

(56) References cited:
- EP-A1- 0 378 116
- WO-A1-01/25503
- WO-A1-83/03245
- WO-A1-96/33955
- WO-A1-2014/177651

## Description

### [Field of the invention]

The present invention relates to a coating apparatus also called coating tunnel or coating hood for applying a protective coating to hollow glass containers.

In particular it relates to a coating apparatus also called coating tunnel or coating hood with the re-use of the coating material containing exhaust from the end of the coating tunnel for applying the protective coatings to glass containers.

More particularly the present invention relates to a coating apparatus also called coating tunnel or coating hood with a specific partial separation of the carrier gas flow of one loop into two respective loops.

### [Technical problem]

Hollow glass containers are produced from molten glass at moulds at high temperatures. As the surface of these containers is fragile and in order to preserve the strength of the glass and to prevent any direct glass to glass contact of the respective containers in order to avoid damage, they are surface coated directly after forming of the container.

Such a coating that includes tin or tin tetrachloride, titanium or other heat decomposable metallic or organometallic compounds protects the glass container surface in from damage such as abrasions and scratches, which result in a loss of tensile strength for the glass container. The need for high tensile strength in a glass container is particularly acute when containers are mass produced, move rapidly in close proximity along high speed conveyor lines.

This coating application is done inside a coating apparatus also called a coating tunnel or coating hood with a so called hot end coating by chemical vapor deposition usually in forming a thin layer of a metal oxide, for example tin oxide. The objective is to coat the outside of the bottle with a homogenous even layer except for the so called finish.

The coating tunnel or coating hood receives the glass containers via a conveyer belt from the glass container making equipment with a relatively high speed, meaning between 0.3 up to 1.5 m/s which corresponds to approximately 90 to 700 glass containers per minute. The temperature of the containers excess 400°C at the surface of the containers, so that when the heat decomposable inorganic metallic or organometallic compound (coating compound) is applied thereto, said compound reacts immediately and is converted to a metal oxide coating. The coating compound is fed in the coating tunnel and circulates inside with the aid of a carrier gas around the passing glass containers.

As the glass containers pass the coating hood at this high speed they risk to draw the coating compound out of the tunnel when leaving the hood through the outlet. The coating compound can attack building components and give health and safety issues. A venting system has to be installed for above mentioned reasons. For avoiding and minimizing this, the carrier gas comprising the coating compound is sucked into an exhaust system and is discarded. Consequently the coating compounds and chemicals are lost and the coating performance in view of introduced coating chemical is rather low.

On the other side when entering the tunnel through the inlet the glass containers draw in fresh air from the outside. In doing so they dilute the coating compound inside the tunnel. In order to apply a minimum necessary coating thickness on the glass containers more coatings compound has to be introduced in order to guarantee the required concentration of the coating chemical in the coating hood or tunnel for the chemical vapor deposition.

There is still the need for more efficient glass coating hoods, with low losses of the coating compound material to the atmosphere.

An objective of the present invention is to have a more homogenous distribution of the coating on the surface of the glass containers.

Another objective of the present invention is to reduce the variation of the thickness of the coating on the glass container surface.

Another objective of the present invention is to lower the discharge of the coating chemical.

An objective of the present invention is to have a lower consumption of the coating chemical while applying the same thickness of coating to the glass container.

Still another objective of the present invention is to lower the emissions of chemicals in the coating area and near the coating tunnel or coating hood.

Again another objective of the present invention is to efficiently reduce the extent of exchange between ambient air and the gas in the tunnel especially at the entry.

An additional objective of the present invention is to provide a coating hood with a better efficiency, coating more bottles at the same time.

Surprisingly it has been found that with a separation of a specific lateral flow of the carrier gas comprising coating compound after it has passed through the coating tunnel by a separator into two distinctive flows, the before mentioned problems can be solved.

### [BACKGROUND OF THE INVENTION]Prior art

Coating apparatus for glass containers and the respective standard components are well known from the prior art.

The document US 4,389,234 (family member of the document WO8303245 identified as D1 in the search report) describes a glass coating hood possessing two or multiple loops. The coating is first fed into an innermost loop and then in an outermost loop. There is also a possibility of using a third loop, but all loops are recirculating loops in order to make better use of the coating material. Consequently the concentration of the coating compound decreases which each recirculating loops in order to make better use of the coating material. Consequently the concentration of the coating compound decreases which each recirculating loop. At the end the non used coating compound enters an exhaust system.

The document US 5,140,940 describes also a double loop coating hood, as described before. The coating apparatus based on its respective embodiments contains single or multiple air circulating loops.

The document EP0378116 describes a hot end coating apparatus. The hot end coating apparatus has two additional separate air circuits in the inlet and outlet region of a vapour-deposition hood. The air circuits produce two opposite flow zones flowing through the vapour-deposition hood in the transverse direction, the inner flow zone being enriched to the maximum degree with a coating agent and the outer flow zone forming a protective air curtain consisting of the used air from the coating zone, the degree of enrichment of the said air being correspondingly lower. However two additional feed points of the coating agent are needed one for each circuit.

The document WO2001/0255503 describes a glass container coating hood having additional loops; in one embodiment one loop of air or in another embodiment the hood uses counter current loops of air for carrying the coating.

The document WO96/33955 describes a method and apparatus for applying a layer to bottles. The method is made by a coating apparatus that comprises a gas curtain screening apparatus arranged before the inlet and/or after the outlet of the coating tunnel. The gas curtain is fed by pure gas, no coating causing chemical is added, nitrogen or ambient air are exemplified, in order to avoid clogging of the outflow openings.

The document WO2014/177651 discloses a coating hood having an air entry and a loop returning the air enriched with the coating compound and carrier gas from the outlet to the inlet of the coating hood.

None of the cited prior art discloses a coating apparatus as described in any of appended claims 1 to 4.

### [Brief description of the invention]

Surprisingly it has been discovered that a coating apparatus as described in one or more of the appended claims 1-4 solves the above mentioned problems.

It has also been found that a process, as described in one of claims 5 to 7, of applying a coating on the surface of glass containers can solve the above mentioned problems.

Surprisingly it has also been discovered that the introduction of such a separator as described in claim 1 to the coating tunnel of a coating apparatus for applying a coating on glass containers with a chemical compound, yields to a more homogenous distribution of the coating on the surface of the glass containers and/or reduces the consumption of the coating chemical and/or lower the discharge of the coating chemical.

The invention is best understood from the following detailed description when read in connected with the accompanying drawings with the following figures:
Figure 1: schematic representation of existing hood from the state of the art with a recirculation loop.
Figure 2: schematic representation of existing hood from the state of the art with a recirculation loop (8) and half open loop (9) .
Figure 3a and 3b: schematic representation of the hood according to one embodiment of the present invention with separator (25) and respective loops.
Figure 4: schematic representation of some embodiments of the separator (25).

### [Detailed description of the invention]

In a first aspect, the present invention relates to a coating apparatus for applying a coating glass on containers with a chemical compound, as described in one or more of claims 1 to 4.

In a second aspect the present invention relates to a process of applying a coating on the surface of glass containers, as described in one or more of claims 5 to 7.

According to an additional aspect the present invention relates to the use of a coating apparatus according to any of claims 1 to 4 for applying a coating on the surface of a glass container.

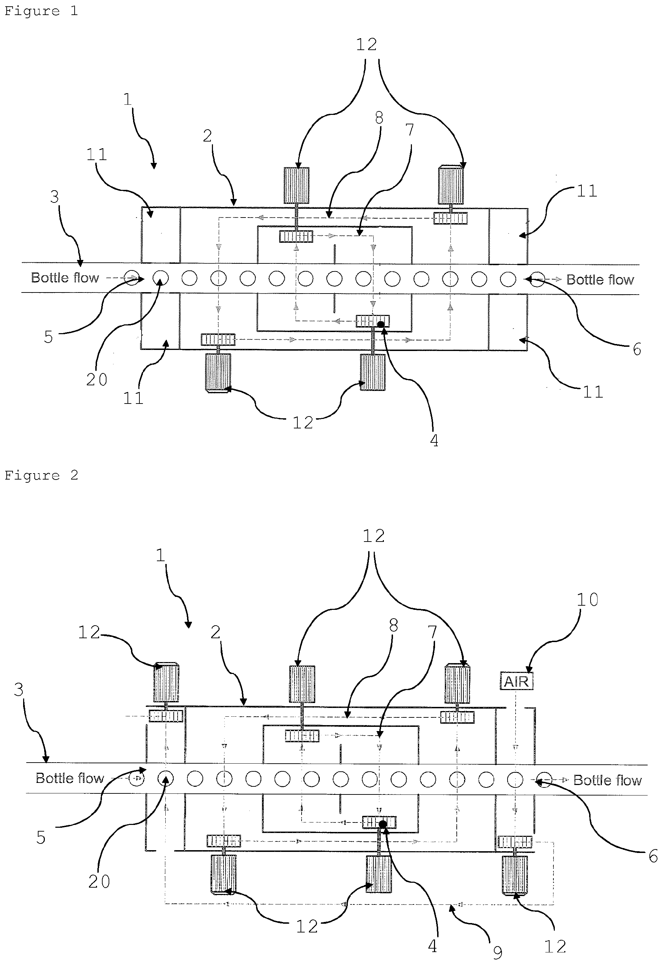

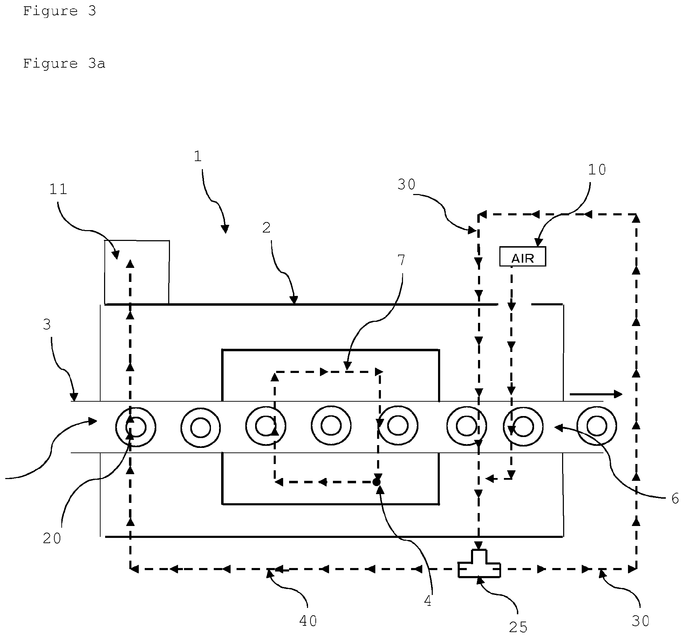

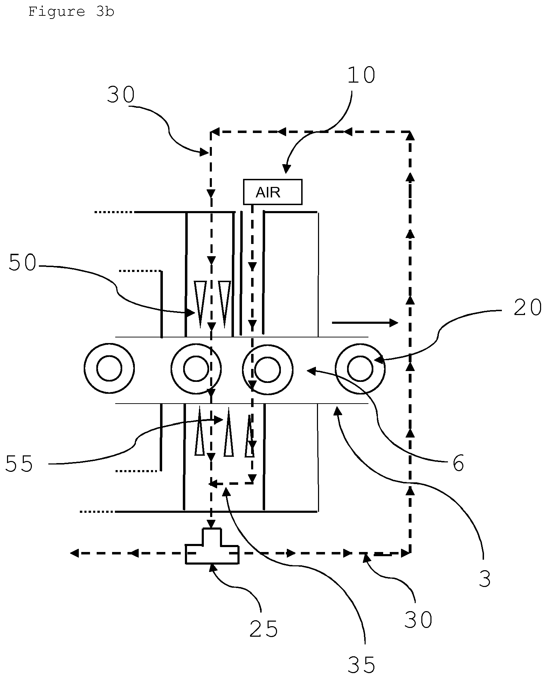

According to a variation of the present invention the coating apparatus can also comprise one or more recirculating loops (8). The recirculating loop or loops (8) is or are after the primary loop (7) and before the carrier gas flow that is separated, in the sense of the direction of the passing containers on the conveyer belt. Such a recirculating loop (8) is not shown in figure 3, but is well known from prior art as presented in figure 1 or 2.

By the generic term "air" as used is denoted the carrier gas that is used for the coating compound. It is obvious that any inert gas or a gas that is inert to the coating compound, the container and the interior of the coating hood, such as nitrogen could be used. Because of its convenience and low cost however the preferred gas is air.

By the term "coating compound" as used in the present invention is denoted a chemical compound that is introduced in the coating apparatus. The coating compound is used directly to coat a surface or it is transformed during the coating application in another compound that forms the coating.

By the term "exhaust" as used is denoted the carrier gas that is still loaded with a minor quantity of the coating compound not applied to the glass container that escapes at the entry and especially the outlet of the coating tunnel, where the containers enter and sort.

By the term "loop" as used in the present invention is denoted a circuit for the carrier gas or air loaded with the coating compound that enters and leaves the coating tunnel. Such a loop comprises at least a jet slot and a least one receiving slot that are located on the opposite side wall of the hood. The loop could comprises also conduits in form of tubes and pipes. These conduits in form of tubes and pipes are necessary to transport the carrier gas from the receiving slot to the jet slot

By the term "primary loop" as used in the present invention is denoted a circuit that comprises at least a feed point of the coating compound and circulates the carrier gas loaded with the coating compound or air loaded with the coating compound. The loop or circuit enters and leaves twice the coating tunnel by respective jet slots and receiving slots. In other words the loop or circuit makes a complete 360° turn.

By the term "recirculating loop" as used in the present invention is denoted a circuit that does not comprise any feed point and that recirculates the carrier gas loaded with the coating compound or air loaded with the coating compound coming from the primary loop.

By the term "return loop" as used is denoted a circuit of carrier gas loaded with the coating compound or air loaded with the coating compound that enters once and leaves once the coating tunnel. The return loop or circuit makes a 360° turn. The end and the beginning of this loop have a common point

By the term "recycle loop" as used is denoted a circuit of carrier gas loaded with the coating compound or air loaded with the coating compound that enters once and leaves once the coating tunnel. The recycle loop or circuit makes a 180° turn. The end and the beginning of this loop have no common point.

By the term "separator" as used is denoted a mean that separates one flow of carrier gas loaded with the coating compound or air loaded with the coating compound in at least two distinctive flows in different directions.

**With regard to the coating apparatus from the prior art,** an embodiment of said coating apparatus is shown in figure 1. The coating apparatus comprises a housing (2) with coating tunnel, a conveyer belt (3) moving the containers (20) through the coating tunnel from the inlet (5) to the outlet (6) of the said coating tunnel, one primary loop (7) with a least one feed point (4) for the coating compound, one or more recirculating loops (8), blowing means (12) and exhaust means (11) in proximity of the inlet (5) end outlet (6). Details of such a coating apparatus and its components can be found in document US 4,668,268 or US 4,389,234.

**Still with regard to the coating apparatus from the prior art,** another embodiment of such a coating apparatus is shown in figure 2. Said coating apparatus comprises a housing (2) with coating tunnel, a conveyer belt (3) moving the containers (20) through the coating tunnel from the inlet (5) to the outlet (6) of the said coating tunnel, one primary loop (7) with a least one feed point (4) for the coating compound, blowing means (12), optionally one or more recirculating loops (8) and a half open loop (9) going from the outlet (6) to the inlet (5) of the coating tunnel. Details of such a coating apparatus and its components can be found in document WO2014/177651.

**With regard to the coating apparatus of** the present invention, it is shown schematically in figure 3, said coating apparatus comprises a housing (2) with coating tunnel, a conveyer belt (3) moving the containers (20) through the coating tunnel from the inlet (5) to the outlet (6) of the said coating tunnel, one primary loop (7) with a least one feed point (4) for the coating compound, blowing means (12), and a separator (25) of the carrier gas flow coming from the coating tunnel, that separates the carrier gas flow loaded with the coating compound in at least two distinctive flows, one part of the carrier gas loaded with the coating compound in a first circuit called return loop (30) and the other part of the carrier gas loaded with the coating compound in another second circuit called recycle loop (40) going to the inlet (5) of the coating tunnel.

Optionally the **coating apparatus of** the present invention can comprise one or more recirculating loops.

In a one embodiment the coating hood according to the invention comprises additionally one or more recirculating loops.

The position of the recirculating loop or recirculating loops can be behind the primary loop (in view of the movement of the conveyer belt) or around the primary loop, latter possibility as shown in figure 1 and 2 of the coating apparatus from the prior art.

Additionally the coating apparatus comprises at least one jet slot (50) and receiver slot (55), which are not shown in the figure 3a. The slots are respectively the entry or exit of each respective loop towards or from the central chamber of the coating tunnel, where the conveyer belt with the containers passes. By the jet slot the coating compound or carrier gas enters this chamber. By the receiver slot the coating compound or carrier gas leaves this chamber.

Preferably each loop of the coating apparatus comprises at least one jet slot and receiver slot.

Additionally the coating apparatus comprises blowing means or blowers (12). These blowers (12) keep the carrier gas with the coating compound circulating inside the hood and make it passing through the respective loops. The blower can either push the carrier gas with coating compound forward inside the centre section of the tunnel where the conveyer belt with the container passes or suck it outside.

Preferably each loop comprises at least one blower (12).

**Preferably the coating apparatus of** the present invention comprises at least three loops: one primary loop (7), one return loop (30) and one recycle loop (40). With regard to the loops, the schematic drawing in figure 3a has one primary loop, one return loop (30) and one recycle loop (40). The primary loop is an inner loop (7). In the two other loops, the return loop (30) and the recycle loop (40) respectively, the carrier gas comprising the coating compounds is transported in different directions. The direction is relative to the movement of the containers on the conveyer belt. In the recycle loop (40) the carrier gas comprising the coating compound is transported and reintroduced in the coating tunnel before the primary loop (7). In the return loop (30) the carrier gas comprising the coating compound is transported and reintroduced in the coating tunnel after the primary loop (7) .

The concentration of the coating compound in the carrier gas circulated in the return loop (30) and the recycle loop (40) is less than in the primary loop (7). The expression "carrier gas loaded with the coating compound" means that the carrier gas comprises the coating compound, without any information of the concentration of said coating compound in the carrier gas.

In the embodiment shown in figure 3 the coating apparatus comprises one primary loop one return loop (30) and one recycle loop (40). The coating apparatus in figure 3 is one embodiment according to the present invention that has no recirculating loop.

**The coating apparatus of** the present invention comprises at least a separator (25). The separator (25) separates carrier gas comprising the coating compound. The separator (25) separates carrier gas comprising the coating compound that at least one part carrier gas comprising the coating compound is continuing into the return loop (30) and at least another part carrier gas comprising the coating compound is continuing into recycle loop (40).

**With regard to the separator (25),** it is situated behind or downstream in view of the flow of carrier gas loaded with the coating compound or air loaded with the coating compound that crosses more or less perpendicularly the central part of the coating tunnel, where the containers are passing on the conveyer belt. Preferably the carrier gas loaded with the coating compound or air loaded with the coating compound, that is separated by the separator (25) is coming from the coating tunnel through one or several receiver slots (55). These receiver slots (55) are situated at the side of the coating tunnel between the primary loop and the exit outlet.

The separator (25) separates the carrier gas loaded with the coating compound or air loaded with the coating compound coming from the central part of coating tunnel where the containers are passing on the conveyer belt. The separator (25) separates the carrier gas loaded with the coating compound or air loaded with the coating compound in two distinctive flows.

The separator can have different forms. Two examples are given in figure (4) where the separator has a simple "T" or "Y" like form. Other geometries are easily imaginable with the requirement to separate an incoming flow in two distinctive flows.

The separator does not to be a separate piece, if it just fulfills its function. For example one end of a straight conduit or tube connected the middle section of another straight conduit or tube forms automatically the separator around bonding section of the two conduits.

The coating compound is introduced through at least one feed point (4) in to the coating apparatus. This can be an internal feed point as in figure 1, 2 or 3 or an external feed point.

In one embodiment the feed point (4) is based at the primary loop (7) as an internal feed point as shown in figure 1, 2 and 3. The coating compound is introduced by the means of pipes, latter are not shown in the figures.

In another embodiment the coating compound is introduced by hot recirculating air as a side stream to dose the coating compound in, which is an external feed.

The concentration of the coating compound in the carrier gas or air is the highest in the primary loop. The concentration of the coating compound in the carrier gas or air is less in the other loops. As the conveyer belt passes through the part of the coating tunnel where the primary loop is situated with relatively high speed, a part of the carrier gas loaded with the coating compound or air loaded with the coating compound is carried down the central part of the coating tunnel.

The hollow glass containers are transported in a single or double line by a conveyer through a tunnel formed in the coating hood under the housing. The conveyer carries the bottles in the direction designated by the arrow, in figures 1, 2 and 3 from left to right.

**With regard to the return loop (30),** it goes from the separator (25) to the other side of the coating tunnel and the carrier gas loaded with the coating compound is reintroduced in to the coating tunnel through a jet slot.

The carrier gas loaded with the coating compound coming from the return loop (30) is reintroduced in to the coating tunnel between the primary loop (7) and the end or outlet (6) of the coating tunnel. By end or outlet (6) is meant the part of the hood where the coated containers are leaving the hood. The reintroduction of carrier gas loaded with the coating compound into the coating tunnel is made through a jet slot (50).

If the coating apparatus should have a recirculating loop, the carrier gas coming from the return loop (30) is reintroduced in to the coating tunnel between the recirculating loop and the end or outlet (6) of the coating tunnel.

**With regard to the recycle loop (40),** it goes from the separator (25) of the coating hood to the proximity of the entry or inlet (5) of the coating hood (1) with a perpendicular introduction in view of the movement of the containers on the conveyer belt. By entry or inlet is meant the opening where the not yet coated containers enter the coating hood. By proximity is meant that between the primary loop and the entry. The recycle loop comprises at least one exhaust and jet slot.

The carrier gas loaded with the coating compound coming from the recycle loop (40) is reintroduced in to the coating tunnel between the primary loop(7) and the entry or inlet (5) of the coating tunnel. By the entry or inlet (5) is meant the part of the hood where the containers are entering the hood.

If the coating apparatus should have a recirculating loop, the carrier gas coming from the recycle loop (40) is reintroduced in to the coating tunnel between the recirculating loop and the entry or inlet (5) of the coating tunnel.

Preferably the coating hood according to the invention comprises an inlet for fresh air (10).

Fresh air (10) is introduced before the end of the coating hood, which is enriched with the hot carrier gas coming from the central area of the coating hood. Preferably the fresh air is introduced by a jet slot. The fresh air is introduced by a jet slot at the opposite side of the separator (25). The air is enriched with the coating compound still present in the hot carrier gas.

The jet slot of the air inlet is in proximity of the outlet of the coating tunnel. By proximity is meant that the air inlet is between the outlet of the coating tunnel and the last loop, which is the return loop (30), in direction of the movement of the conveyer belt.

The air inlet at the outlet creates a lateral air flow in view of the bottle transport direction, meaning the movement of the conveyer belt. This lateral air flow creates a kind of curtain reducing the amount of carrier gas comprising still non used coating compound that might escape the coating apparatus or has to be exhausted.

The air coming from the air inlet is also mixed (35) with the carrier gas loaded with the coating compound coming from the return loop (30)that is reintroduced in the coating tunnel. The mixing starts or takes place before the separator (25).

The separator (25) separates this mixture of air enriched with the coating compound and recycled carrier gas in at least two loops. The first loop is the return loop (30). The second loop is the recycle loop (40) going to the inlet of the coating hood.

At least a part of the non used coating compound is reentering the coating process and is not lost or have not to be exhausted and discarded.

The return loop (30) comprises at least one blower (12) for circulating the mixture of air and carrier gas loaded with the coating compound from the separator around the hood for reintroducing it into the coating hood.

When the containers enter into the hood on a fast speed conveyer belt fresh air is sucked in at the inlet by a coating apparatus according to the prior art as in figure 1.

The recycle loop (40) according to the invention transports the air enriched with the coating compound and carrier gas from the outlet to the inlet of the coating hood. A kind of gas curtain is established at the inlet of the coating hood. This gas curtain comprises already hot carrier gas with a certain content of coating compound. This reduces enormously the amount of fresh air which is sucked in at the inlet. This avoids the dilution of the carrier gas of the first loop in direction of the conveyer belt.

The gas curtain at the inlet creates a lateral air flow in view of the bottle transport direction, meaning the movement of the conveyer belt.

Additionally the containers just entering the coating apparatus at the inlet might already begin to get slightly coated as this gas curtain comprises already hot carrier gas with a certain content of non used coating compound.

Additionally the temperature of the carrier gas in side the coating apparatus decreases less by the introduction of ambient air as this gas curtain comprises already hot carrier gas with a certain content of non used coating compound.

In one embodiment the recycle loop comprises preferably at its end an exhaust mean (11).

Additionally the coating apparatus according to the invention can comprise means for exhaust. This can be either at the inlet or at the outlet or at the inlet and the outlet additional exhaust means are present.

**With regard to the coating compound** introduced in the coating apparatus at one or more feedings points, it can be chosen from organometallic compounds, metal halides or other suitable compounds as coating compound precursor.

Preferably the coating compound is an organic tin halogenide, advantageously it is monobutyl tin trichloride.

**With regard to the coating** formed at the surface of the containers and applied in the hood it is a metal oxide as SnO2, TiO2, Al2O3 or ZnO. The metal oxide is derived from the decomposition inorganic or organometallic compounds.

Preferable the coating is tin oxide. The tin oxide is derived from the decomposition inorganic or organic tin compound advantageously of an organic tin halogenide, more advantageously from monobutyl tin trichloride.

**With regard to the process** of applying a coating on the surface of glass containers, it is implemented on the apparatus of claim 1 and it comprises the steps described in claim 5.

The process of applying a coating on the surface of glass containers comprises also the step d) of introducing fresh air (10) at the proximity of the outlet (6) of the coating tunnel. By proximity is meant that the introduction of fresh air take place between the outlet and the last loop that enters the coating tunnel.

Advantageously said air is mixed with at least a part of carrier gas comprising the coating generating compound.

More advantageously said air is mixed with at least a part of carrier gas comprising the coating generating compound which is reintroduced into the coating tunnel with a jet slot coming from the return loop.

Optionally step b) comprises also one or more recirculating loops (8).

In one optionally embodiment the process of applying a coating on the surface of glass containers, it comprises after blowing the gas comprising the coating generating compound with the primary loop through the coating tunnel, additionally the step of blowing the gas comprising the coating generating compound with one or more recirculating loops through the coating tunnel.

The coating apparatus according to the invention is used to apply a coating on the surface of a glass containers.

### [Figures]

**Figure 1****:** schematic representation of existing hood from the state of the art with a recirculating loop.

Coating compound is introduced into the coating apparatus (1) or hood at a feed point (4). The hood (1) comprises a housing (2) and a conveyer belt (3) running there through. Containers (20) are transported on the belt, which moves them from the entrance or inlet (5) to the exit outlet (6) of the hood (1).

The containers (20) are only presented diagrammatically by circles.

The hood also comprises one primary loop (7) with a least one feed point (4) for the coating compound, one or more recirculating loops (8) and exhaust means (11) in proximity of the inlet (5) end outlet (6).

**Figure 2****:** schematic representation of existing hood from the state of the art with primary loop and with an additional half loop (9).

Coating compound is introduced into the coating apparatus (1) or hood at a feed point (4). The hood (1) comprises a housing (2) and a conveyer belt (3) running there through. Containers (20) are transported on the belt that moves them from the entrance or inlet (5) to the exit outlet (6) of the hood (1).

The containers (20) are only presented diagrammatically by circles.

The hood also comprises one primary loop (7) with a least one feed point (4) for the coating compound, one or more recirculating loops (8) and a half open loop (9) going from the outlet (6) to the inlet (5) of the coating tunnel.

**Figure 3a****:** schematic representation of the hood according to one embodiment of the present invention with a separator (25).

Coating compound is introduced into the coating apparatus (1) or hood at a feed point (4). The hood (1) comprises a housing (2) and a conveyer belt (3) running there through. Containers (20) are transported on the belt that moves them from the entrance or inlet (5) to the exit outlet (6) of the hood (1).

The containers (20) are only presented diagrammatically by circles.

The hood also comprises one primary loop (7) or inner loop with a least one feed point (4) for the coating compound, one entry of fresh air (10). Passing through the hood after the primary loop (7) is a carrier gas flow which is separated after passing the central part of the hood where the containers (20) are passing on the conveyer belt (3) in at least two flows by a separator (25). The first of the two flows (40) so called recycle loop is going to the entry (5) (entering the hood laterally between entry and inner loop) and the second flow (30) so called return loop is returned to its entry point.

The hood also comprises an air entry (10) between the outlet (6) and the entry point of the return loop. The air is mixed (35) with the carrier gas comprising coating compound before coming to separator (25).

**Figure 3b****:** more detailed schematic representation of a part of the hood according to one embodiment of the present invention with a separator (25). This figure comprises also the jet slots (50) and receiver slots (55) in the return loop (30). The air coming from the air entry (10) and the carrier gas circulating in the loops are mixed before the separator (25). The mixing at the point (35) is only symbolically as the partial mixing of the two flows can already take place after the entry of the two flows by the respective slots in the central part of the coating hood where the conveyer belt (3) is passing.

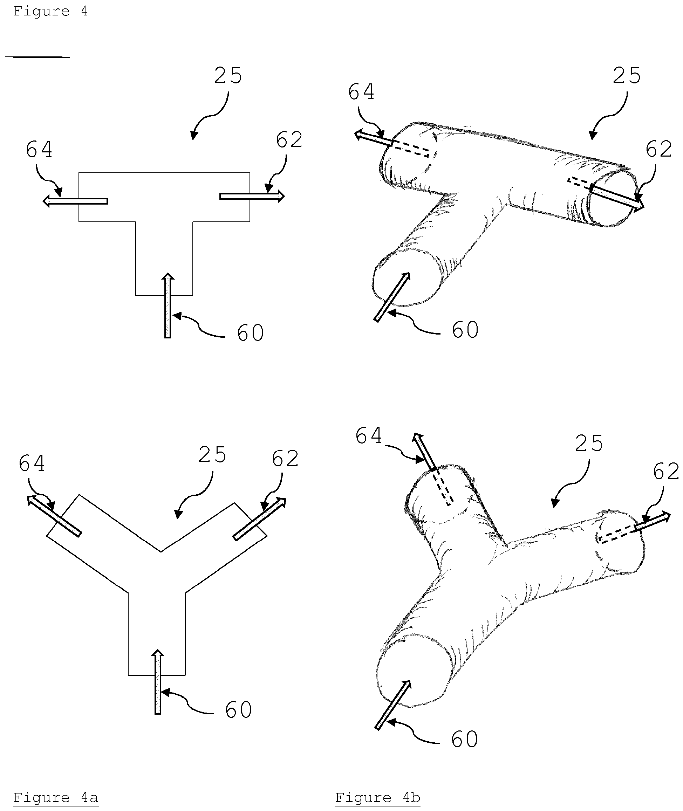

**Figure 4****:** schematic representation of the separator (25) according to different embodiments of the present invention. The separator could be part of two connected conduits or tubes.

The separator (25) given in top view at the left and perspective view at the right may have the form of a "T" or a "Y" as given by the schemes in figure 4a) and 4b). The separator (25) separates the carrier gas flow (60) coming from the coating tunnel, separating the carrier gas flow in at least two distinctive flows (62) and (64) and directions. For example first flow (62) going into recycle loop (40) and second flow (64) going to return loop (30). The respective loops (30) and (40) are not shown in figure 4.

## Claims

1. A coating apparatus (1) for applying a coating on glass containers with a chemical compound comprising:
a housing (2) with a coating tunnel
a conveyer belt (3) moving the containers (20) through the coating tunnel from the inlet (5) to the outlet (6) of the said coating tunnel
one primary loop (7)
a separator (25) that separates the carrier gas flow loaded with the coating compound coming from the coating tunnel in at least two distinctive flows and
an air inlet (10) for fresh air in proximity of the outlet (6) of the coating tunnel,
wherein the separator (25) separates the carrier gas flow loaded with the coating compound in one first part of the carrier gas loaded with the coating compound in a first circuit called return loop (30) and the other part of the carrier gas loaded with the coating compound in another second circuit called recycle loop (40) going to the proximity of the inlet (5) of the coating tunnel, and
wherein the separator (25) is situated behind or downstream in view of the flow of carrier gas loaded with the coating compound or air loaded with the coating compound that crosses more or less perpendicularly the central part of the coating tunnel, where the containers are passing on the conveyer belt, and
wherein the return loop (30) goes from the separator (25) to the other side of the coating tunnel and the carrier gas loaded with the coating compound is reintroduced in to the coating tunnel through a jet slot (50), and
wherein carrier gas loaded with the coating compound coming from the recycle loop (40) is reintroduced in to the coating tunnel between the primary loop (7) and the entry or inlet (5) of the coating tunnel, and
wherein the fresh air is introduced by a jet slot at the opposite side of the separator (25).

2. A coating apparatus according to claim 1, wherein each loop comprises at least one jet slot and receiver slot.

3. A coating apparatus according to claim 1 wherein the separator has has a "T" or "Y" like form.

4. A coating apparatus according to any of claims 1 to 3, wherein the coating apparatus comprises means for exhaust.

5. A process of applying a coating on the surface of glass containers implementing the apparatus according to claim 1, comprising the steps of:
- conveying the glass containers (20) through a coating tunnel from the inlet (5) to the outlet (6),
- blowing gas comprising the coating generating compound with a primary loop (7) and optionally one or more recirculating loops (8) through the coating tunnel,
- separating a part of the carrier gas loaded with the coating compound circulating through the coating tunnel, after the primary loop, said gas is separated after passage of the coating tunnel by a separator (25) in two distinctive circuits, one circuit called recycle loop (40) going to the inlet (5) of the coating tunnel and the other circuit called return loop (30) is returning a part of the carrier gas loaded with the coating compound in order to be reintroduced into the coating tunnel
- introducing fresh air (10) at the proximity of the outlet (6) of the coating tunnel

6. The process according to claim 5 wherein said air is mixed with the at least a part of carrier gas comprising the coating generating compound.

7. The process according to claim 5 wherein said air is mixed with at least a part of carrier gas comprising the coating generating compound which is reintroduced into the coating tunnel with a jet slot coming from the return loop (40).

8. Use of a coating apparatus according to any of claims 1 to 4 for applying a coating on the surface of a glass container.

## Patentansprüche

1. Beschichtungsvorrichtung (1) zum Aufbringen einer Beschichtung auf Glasbehälter mit einer chemischen Verbindung, die Folgendes umfasst:
ein Gehäuse (2) mit einem Beschichtungstunnel,
ein Förderband (3), das die Behälter (20) durch den Beschichtungstunnel von dem Eingang (5) zu dem Ausgang (6) des Beschichtungstunnels bewegt,
eine Primärschleife (7),
eine Trennvorrichtung (25), die den von dem Beschichtungstunnel kommenden Trägergasstrom, der mit der Beschichtungsverbindung angereichert ist, in mindestens zwei individuelle Ströme trennt, und
einen Lufteinlass (10) für Frischluft in der Nähe des Ausgangs (6) des Beschichtungstunnels,
wobei die Trennvorrichtung (25) den mit der Beschichtungsverbindung angereicherten Trägergasstrom in einen ersten Teil des mit der Beschichtungsverbindung angereicherten Trägergases in einem ersten Kreislauf, der als Rückführungsschleife (30) bezeichnet wird, und den anderen Teil des mit der Beschichtungsverbindung angereicherten Trägergases in einem anderen zweiten Kreislauf, der als Rezyklierungsschleife (40) bezeichnet wird und in die Nähe des Eingangs (5) des Beschichtungstunnels führt, trennt, und
wobei sich die Trennvorrichtung (25) bezüglich des mit der Beschichtungsverbindung angereicherten Trägergasstroms oder mit der Beschichtungsverbindung angereicherter Luft, die den mittigen Teil des Beschichtungstunnels mehr oder weniger senkrecht durchkreuzt, dahinter oder stromabwärts befindet, wobei die Behälter auf dem Förderband durchlaufen, und
wobei die Rückführungsschleife (30) von der Trennvorrichtung (25) zu der anderen Seite des Beschichtungstunnels führt und das mit der Beschichtungsverbindung angereicherte Trägergas durch einen Strahlschlitz (50) wieder in den Beschichtungstunnel eingeleitet wird, und
wobei aus der Rezyklierungsschleife (40) kommendes mit der Beschichtungsverbindung angereichertes Trägergas zwischen der Primärschleife (7) und dem Zugang oder Eingang (5) des Beschichtungstunnels wieder in den Beschichtungstunnel eingeleitet wird, und
wobei die Frischluft durch einen Strahlschlitz auf der gegenüberliegenden Seite der Trennvorrichtung (25) eingeleitet wird.

2. Beschichtungsvorrichtung nach Anspruch 1, wobei jede Schleife mindestens einen Strahlschlitz und einen Aufnahmeschlitz umfasst.

3. Beschichtungsvorrichtung nach Anspruch 1, wobei die Trennvorrichtung eine "T"- oder "Y"-artige Form aufweist.

4. Beschichtungsvorrichtung nach einem der Ansprüche 1 bis 3, wobei die Beschichtungsvorrichtung Auslassmittel umfasst.

5. Verfahren zum Aufbringen einer Beschichtung auf der Oberfläche von Glasbehältern unter Implementierung der Vorrichtung nach Anspruch 1, das die folgenden Schritte umfasst:
- Transportieren der Glasbehälter (20) durch einen Beschichtungstunnel von dem Eingang (5) zu dem Ausgang (6),
- Blasen von die Beschichtungserzeugungsverbindung umfassendem Gas mit einer Primärschleife (7) und optional einer oder mehreren Rezirkulierungsschleifen (8) durch den Beschichtungstunnel,
- Abtrennen eines Teils des mit der Beschichtungsverbindung angereicherten Trägergases, das durch den Beschichtungstunnel zirkuliert, nach der Primärschleife wird das Gas nach dem Durchströmen des Beschichtungstunnels von einer Trennvorrichtung (25) in zwei individuelle Kreisläufe getrennt, wobei ein als Rezyklierungsschleife (40) bezeichneter Kreislauf zu dem Eingang (5) des Beschichtungstunnels führt und der als Rückführungsschleife (30) bezeichnete andere Kreislauf einen Teil des mit der Beschichtungsverbindung angereicherten Trägergases zur Wiedereinleitung in den Beschichtungstunnel zurückführt,
- Einleiten von Frischluft (10) in der Nähe des Ausgangs (6) des Beschichtungstunnels.

6. Verfahren nach Anspruch 5, wobei die Luft mit dem mindestens einen Teil von die Beschichtungserzeugungsverbindung umfassendem Trägergas vermischt wird.

7. Verfahren nach Anspruch 5, wobei die Luft mit mindestens einem Teil von von der Rückführungsschleife (40) kommendem die Beschichtungserzeugungsverbindung umfassendem Trägergas, das mit einem Strahlschlitz wieder in den Beschichtungstunnel eingeleitet wird, vermischt wird.

8. Verwendung einer Beschichtungsvorrichtung nach einem der Ansprüche 1 bis 4 zum Aufbringen einer Beschichtung auf der Oberfläche eines Glasbehälters.

## Revendications

1. Appareil d'enduction (1) pour appliquer un revêtement sur des récipients en verre avec un composé chimique, comprenant :
un boîtier (2) avec un tunnel d'enduction,
une courroie transporteuse (3) déplaçant les récipients (20) à travers le tunnel d'enduction depuis l'entrée (5) jusqu'à la sortie (6) dudit tunnel d'enduction,
une boucle primaire (7),
un séparateur (25) qui sépare l'écoulement de gaz porteur chargé avec le composé d'enduction provenant du tunnel d'enduction en au moins deux écoulements distincts et
une entrée d'air (10) pour l'air frais à proximité de la sortie (6) du tunnel d'enduction,
dans lequel le séparateur (25) sépare l'écoulement de gaz porteur chargé avec le composé d'enduction dans une première partie du gaz porteur chargé avec le composé d'enduction en un premier circuit appelé boucle de retour (30) et l'autre partie du gaz porteur chargé avec le composé d'enduction en un autre, deuxième, circuit appelé boucle de recyclage (40) allant jusqu'à proximité de l'entrée (5) du tunnel d'enduction, et
dans lequel le séparateur (25) est situé derrière ou en aval, en regardant l'écoulement du gaz porteur chargé avec le composé d'enduction ou l'air chargé avec le composé d'enduction qui traverse, plus ou moins perpendiculairement, la partie centrale du tunnel d'enduction, où les récipients passent sur la courroie transporteuse, et
dans lequel la boucle de retour (30) va du séparateur (25) à l'autre côté du tunnel d'enduction et le gaz porteur chargé avec le composé d'enduction est réintroduit dans le tunnel d'enduction à travers une fente à jet (50), et
dans lequel le gaz porteur chargé avec le composé d'enduction provenant de la boucle de recyclage (40) est réintroduit dans le tunnel d'enduction entre la boucle primaire (7) et l'admission ou l'entrée (5) du tunnel d'enduction, et
dans lequel l'air frais est introduit par une fente à jet au niveau du côté opposé du séparateur (25) .

2. Appareil d'enduction selon la revendication 1, dans lequel chaque boucle comprend au moins une fente à jet et une fente de réception.

3. Appareil d'enduction selon la revendication 1, dans lequel le séparateur présente une forme en « T » ou en « Y ».

4. Appareil d'enduction selon l'une quelconque des revendications 1 à 3, dans lequel l'appareil d'enduction comprend un moyen d'échappement.

5. Procédé pour l'application d'un revêtement sur la surface de récipients en verre mettant en oeuvre l'appareil selon la revendication 1, comprenant les étapes consistant à :
- transporter les récipients en verre (20) à travers un tunnel d'enduction depuis l'entrée (5) jusqu'à la sortie (6),
- souffler du gaz comprenant le composé générant le revêtement avec une boucle primaire (7) et éventuellement une ou plusieurs boucles de recirculation (8), à travers le tunnel d'enduction,
- séparer une partie du gaz porteur chargé avec le composé d'enduction circulant à travers le tunnel d'enduction, après la boucle primaire, ledit gaz étant séparé après le passage du tunnel d'enduction par un séparateur (25) en deux circuits distincts, un circuit appelé boucle de recyclage (40) allant à l'entrée (5) du tunnel d'enduction et l'autre circuit appelé boucle de retour (30) ramenant une partie du gaz porteur chargé avec le composé d'enduction afin qu'il soit réintroduit dans le tunnel d'enduction,
- introduire de l'air frais (10) à proximité de la sortie (6) du tunnel d'enduction.

6. Procédé selon la revendication 5, dans lequel ledit air est mélangé avec l'au moins une partie du gaz porteur comprenant le composé générant le revêtement.

7. Procédé selon la revendication 5, dans lequel ledit air est mélangé avec au moins une partie du gaz porteur comprenant le composé générant le revêtement qui est réintroduit dans le tunnel d'enduction avec une fente à jet provenant de la boucle de retour (40).

8. Utilisation d'un appareil d'enduction selon l'une quelconque des revendications 1 à 4 pour appliquer un revêtement sur la surface d'un récipient en verre.
